(19) Europäisches Patentamt
European Patent Office
Office européen des brevets

(11) **EP 2 702 841 B1**

(12) **EUROPÄISCHE PATENTSCHRIFT**

(45) Veröffentlichungstag und Bekanntmachung des Hinweises auf die Patenterteilung:
**14.10.2015 Patentblatt 2015/42**

(21) Anmeldenummer: **12717660.0**

(22) Anmeldetag: **20.04.2012**

(51) Int Cl.:
**H05K 3/46** (2006.01)      **H05K 1/02** (2006.01)
**H05K 1/14** (2006.01)

(86) Internationale Anmeldenummer:
**PCT/EP2012/057306**

(87) Internationale Veröffentlichungsnummer:
**WO 2012/146547 (01.11.2012 Gazette 2012/44)**

(54) **LEITERPLATTENANORDNUNG MIT EINEM SCHWINGFÄHIGEN SYSTEM**

PRINTED CIRCUIT BOARD ARRANGEMENT COMPRISING AN OSCILLATORY SYSTEM

ENSEMBLE CARTE DE CIRCUITS IMPRIMÉS DOTÉ D'UN SYSTÈME POUVANT EFFECTUER UN MOUVEMENT OSCILLATOIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.04.2011 DE 102011017692**

(43) Veröffentlichungstag der Anmeldung:
**05.03.2014 Patentblatt 2014/10**

(73) Patentinhaber: **Robert Bosch GmbH**
**70442 Stuttgart (DE)**

(72) Erfinder: **HANSEN, Uwe**
**72076 Tuebingen (DE)**

(56) Entgegenhaltungen:
**JP-A- 5 149 967        US-A1- 2009 082 995**
**US-A1- 2011 075 384**

**Beschreibung**

Stand der Technik

Die Erfindung betrifft eine Leiterplattenanordnung, insbesondere eine Multilayer-Leiterplatte. Die Leiterplattenanordnung umfasst wenigstens zwei parallel zueinander angeordnete und miteinander verbundene Leiterplatten.

Bei aus dem Stand der Technik bekannten Leiterplatten, welche mit elektronischen Bauelementen, beispielsweise mit Sensoren bestückt sind, wurde das Problem erkannt, dass die Leiterplatten zusammen mit den darauf angeordneten Bauelementen zu Eigenschwingungen angeregt werden können, welche ein von dem Sensor zu erfassendes Erfassungsergebnis beeinträchtigen können. Dieses Problem stellt sich beispielsweise bei Sensoren, welche als Schwingungsempfänger ausgebildet sind, beispielsweise bei Mikrofonen, Drucksensoren oder Beschleunigungssensoren. Weiter kann das Problem bestehen, dass eine Schwingungsfrequenz der Leiterplatte in einen Erfassungsfrequenzbereich des Sensors fällt und so zu einem Erfassungsergebnis führt, das mit der zu erfassenden Messgröße nicht in ursächlichem Zusammenhang steht.

**Neue Beschreibungsseite 1a**

Aus der US 2011 075 384 A1 ist eine Leiterplatte bekannt, bei dem ein elektronisches Bauelement auf einem schwingfähigen Bereich der Leiterplatte angeordnet ist.

Aus der US 2009 082 995 A1 ist eine Leiterplattenanordnung bekannt, bei der zwei zueinander parallel angeordnete Leiterplatten mittels eines flexibel ausgebildeten Elements miteinander verbunden sind.

Offenbarung der Erfindung

Die Erfindung betrifft eine Leiterplattenanordnung nach Anspruch 1.

Erfindungsgemäß ist bei der Leiterplattenanordnung der eingangs genannten Art wenigstens ein Flächenbereich einer Leiterplatte mittels eines elastisch und/oder dämpfend ausgebildeten Elements mit einer anderen Leiterplatte der Leiterplattenanordnung derart verbunden, dass mittels des Flächenbereichs der Leiterplatte und dem Element ein schwingfähiges System, insbesondere ein Feder-Masse-System, ein schwingfähiger Biegestreifen oder eine biegeschwingfähige Platte gebildet ist.

Dadurch kann der Flächenbereich und ein mit dem Flächenbereich verbundenes Bauelement, beispielsweise ein Schwingungsempfänger, welcher ausgebildet ist, in Abhängigkeit einer empfangenen Schwingung ein die Schwingung repräsentierendes Sensorsignal zu erzeugen, insbesondere ein Drucksensor, ein Drehratensensor oder ein Beschleunigungssensor, zusammen mit dem Flächenbereich auf dem elastisch ausgebildeten Element schwingen.

Bevorzugt ist das elastisch ausgebildete Element zusätzlich dämpfend ausgebildet und kann dazu beim Schwingen eine innere Dämpfung ausbilden. Dadurch kann vorteilhaft ein Feder-Masse-System mit einem Schwingungsdämpfer gebildet sein.

Bei einer mehrschichtig aufgebauten Leiterplattenanordnung umfassend wenigstens zwei, bevorzugt mehrere Leiterplattenschichten, kann das elastisch ausgebildete und weiter bevorzugt dämpfend ausgebildete Element vorteilhaft zwischen zwei Leiterplatten angeordnet sein. Die Leiterplatten bilden jeweils eine Schicht der mehrschichtig aufgebauten Leiterplattenanordnung.

Die Leiterplattenanordnung ist beispielsweise eine mehrschichtig ausgebildete HDI-Leiterplatte (HDI = High-Density-Interconnect) oder eine ECP-leiterplatte (ECP = Embedded-Component-Packaging). Leiterbahnen der einzelnen Leiterplatten der Leiterplattenanordnung, insbesondere Multilayer-Leiterplatte, können bevorzugt mittels Durchkontaktierungen, auch Via genannt, miteinander verbunden sein. Mittels der Via's können auch thermische Verbindungen zwischen zueinander benachbarten Leiterplatten gebildet sein.

Bevorzugt ist der Flächenbereich mit einem elektronischen Bauelement verbunden. Das elektronische Bauelement ist beispielsweise ein Mikrofon, ein Beschleunigungssensor, ein Drehratensensor oder ein Drucksensor.

Ein Beschleunigungssensor kann beispielsweise eine seismische Masse und ein mit der Masse verbundenes Piezoelement aufweisen. In einer anderen Ausführungsform ist der Beschleunigungssensor ein Mikromechanik-Sensor, insbesondere ein MEMS-Sensor (MEMS = Micro-Electro-Mechanical-System), welcher ausgebildet ist eine Auslenkung einer Sensormasse kapazitiv zu erfassen. Die Sensormasse wiegt beispielsweise einige Mikrogramm und weist mit Balken verbundene, entlang einer Balkenlängsrichtung zueinander beabstandete Stege auf, die zwischen zwei eine Kapazität bildende Elektroden schwingen können. Die Sensormasse ist beispielsweise in einem elektrischen Feld insbesondere schwingend gehalten. Die Schwingung der Sensormasse kann durch eine auf die Sensormasse wirkende Beschleunigung in Frequenz und/oder Amplitude verstimmt werden, so dass in Abhängigkeit der Verstimmung die Frequenz und/oder Amplitude der Beschleunigung erfasst werden kann.

Bei einem Drehratensensor kann eine Masse eines Beschleunigungssensors in Abhängigkeit einer Fliehkraft einer Drehrate einer Rotation ausgelenkt werden und so die Beschleunigung in Abhängigkeit der Auslenkung, insbesondere einer zur Auslenkung proportionalen Kapazitätsänderung beziehungsweise Piezospannung, erfasst werden.

Der Drucksensor ist bevorzugt ausgebildet, einen statischen Luftdruck, insbesondere eine Änderung des Luftdrucks zu erfassen und ein Sensorsignal zu erzeugen, das den Luftdruck oder die Änderung des Luftdrucks repräsentiert. Dazu kann eine druckempfindliche Membran einer Dose mit einem Piezoelement oder mit einem kapazitiven Element verbunden sein das eine Auslenkung der Membran erfassen kann.

Mittels des elektronischen Bauelements kann vorteilhaft eine zusätzliche Masse gebildet sein, welche mit dem Flächenbereich zusammen auf dem elastisch ausgebildeten Element schwingen kann. Denkbar ist auch ein anderes elektronisches Bauelement, als ein Sensor, beispielsweise ein Mikroprozessor, welcher vibrationsempfindlich ist.

Bevorzugt ist eine Resonanzfrequenz des Feder-Masse-Systems, umfassend den Flächenbereich der Leiterplatte, das elektronische Bauelement und das elastisch ausgebildete Element kleiner als eine Frequenz, welche von dem Sensor erfasst werden kann. Vorteilhaft kann so eine gute Dämpfung der Vibrationen erreicht werden. Weiter vorteilhaft kann der Sensor von einer Resonanz, insbesondere Biegeschwingungs-Resonanz der Leiterplatte entkoppelt werden, die in den Frequenz-Erfassungsbereich des Sensors fällt.

In einer bevorzugten Ausführungsform ist der Flächenbereich von einer zum Flächenbereich benachbarten Fläche der Leiterplatte von Schwingungen, insbesondere Biegeschwingungen entkoppelt, wobei die Leiterplatte eine Aussparung für den Flächenbereich aufweist und der Flächenbereich in der Aussparung angeordnet ist. Beispielsweise ist der Flächenbereich von dem den Flächenbereich umgebenden Flächenbereich mittels Schlitzen, insbesondere gesägten Schlitzen entkoppelt und so getrennt. Die Entkopplung kann beispielsweise mittels einer Säge oder mittels Laserschneiden erzeugt sein. Mittels der so gebildeten Entkopplung kann der Flächenbereich relativ zu dem Flächenbereich der Leiterplatte umgebenden Flächenbereich frei auf dem elastischen Element schwingen.

Bevorzugt ist der Flächenbereich mit der Fläche der Leiterplatte, insbesondere der diesen umgebenden Fläche der Leiterplatte, mittels einer Folie, insbesondere einer Abdeckfolie verbunden. Bevorzugt weist die Folie eine kleinere Dickenabmessung auf als die Leiterplatte. So kann der Zwischenraum, insbesondere ein Spalt zwischen der Leiterplatte und dem schwingfähigen Flächenbereich der Leiterplatte vorteilhaft versiegelt sein. Durch die Versiegelung kann vorteilhaft keine Verschmutzung in den Zwischenraum zwischen den Leiterplatten eindringen. Die Folie ist beispielsweise wenigstens auf einer Seite mit einem Klebstoff beschichtet. Eine solche insbesondere selbstklebende Folie kann auch vorteilhaft nach einem Bestücken der Leiterplatte und auch nach einem Verlöten der elektronischen Bauelemente mit der Leiterplatte den zum Entkoppeln gebildeten Spalt zwischen dem Flächenbereich und der diesen umgebenden Fläche der Leiterplatte verschließen.

In einer bevorzugten Ausführungsform weist das elastisch ausgebildete Element Silikon auf. Durch ein Silikonelement kann das Element vorteilhaft zusätzlich zur elastischen Eigenschaft eine Dämpfungseigenschaft aufweisen. Weiter vorteilhaft ist das Silikonelement weitgehend resistent gegenüber verschiedenen Chemikalien.

In einer anderen Ausführungsform ist das elastisch ausgebildete Element ein Kunststoff-Schaum, insbesondere ein Polyurethan-Schaum. Durch den Kunststoff-Schaum kann das elastische Element vorteilhaft aufwandsgünstig bereitgestellt werden.

Bevorzugt ist das elastisch und/oder dämpfend ausgebildete Element in eine Aussparung der Leiterplatte mittels Spritzen auf die andere Leiterplatte eingefügt. Beispielsweise kann das elastisch ausgebildete Element mittels eines Embedding-Verfahrens in eine Zwischenschicht eingebunden sein. So kann die andere Leiterplatte, welche parallel zu der Leiterplatte benachbart angeordnet ist, als Schwingungsgegenlager und Befestigungspunkt für das elastische Element und den Flächenbereich bilden, welcher mit dem elastischen Element verbunden ist. In einer bevorzugten Ausführungsform ist das elastisch ausgebildete Element zwischen den durch die Leiterplatte und der anderen Leiterplatte gebildeten Ebenen angeordnet. Auf diese Weise kann der Flächenbereich vorteilhaft mit der diesen umgebenden Leiterplatte in derselben Ebene angeordnet sein. Durch die Entkopplung mittels des elastischen Elements wird so in einem mehrschichtigen Leiterplattenverbund nicht mehr Bauraum in der Höhe durch einen Aufbau eines Feder-Masse-Systems verbraucht.

Die Erfindung betrifft auch eine Schaltungsanordnung mit einer Leiterplattehanordnung gemäß der vorbeschriebenen Art. Bei der Schaltungsanordnung ist wenigstens ein Teil von Bauelementen der Schaltungsanordnung mit einem Flächenbereich der Leiterplatte mechanisch und/oder elektrisch verbunden, welcher ein schwingfähiges System, insbesondere ein Feder-Masse-System, einen schwingfähigen Biegestreifen oder eine biegeschwingfähige Platte ausbildet.

Der Flächenbereich weist bevorzugt eine Flächengröße auf, auf welcher der Sensor befestigt werden kann. Beispielsweise weist ein quadratischer Flächenbereich eines Feder-Masse-Systems eine Kantenlänge zwischen einem Zentimeter und fünf Zentimetern auf. Denkbar ist auch ein Schwingfähiges System im Mikrobereich, so dass ein MEMS-Sensor mit einer quadratischen Abmessung mit einer Kantenlänge von 50 Mikrometer ohne eine elektronische Beschaltung des MEMS-Sensors bei dünnen Leiterplatten, beispielsweise mit einer Leiterplattendicke zwischen 100 und 150 Mikrometer der mehrschichtigen Leiterplattenanordnung weniger als einen Millimeter, bevorzugt, weniger als 500 Mikrometer betragen kann, abhängig von der zu erzielenden Resonanzfrequenz,

Figur 1 zeigt ein Ausführungsbeispiel für eine Leiterplattenahordnung mit einem schwingfähigen System gebildet aus einem Flächenbereich einer Leiterplatte und einem Federelement;

Figur 2 zeigt eine Aufsicht auf die in Figur 1 in einer Schnittdarstellung dargestellte Leiterplattenanordnung;

Figur 3 zeigt ein Ausführungsbeispiel für eine Leiterplattenanordnung mit einem schwingfähigen System gebildet aus einem Flächenbereich einer Leiterplatte und einem Dämpfungselement in einer Aufsicht;

Figur 4 zeigt die Leiterplattenanordnung der Figur 3 in einer Schnittdarstellung;

Figur 5 zeigt ein Ausführungsbeispiel für eine Leiterplattenanordnung mit einem schwingfähigen System gebildet aus einem Flächenbereich einer Leiterplatte und einem Dämpfungselement, wobei der Flächenbereich eine Blattfeder mit einem freischwingenden Ende bildet;

Figur 6 zeigt die Leiterplattenanordnung der Figur 5 in einer Schnittdarstellung;

Figur 7 zeigt ein Diagramm mit zwei Transferfunktionen der Leiterplattenanordnung in Figuren 3 und 4:

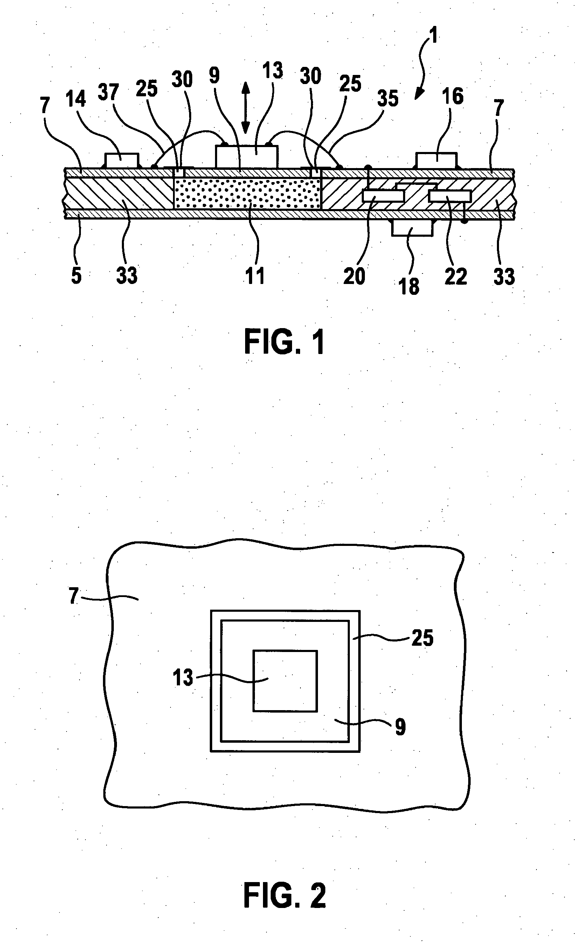

Figur 1 zeigt ein Ausführungsbeispiel für eine Leiterplattenanordnung 1. Die Leiterplattenanordnung 1 weist eine Leiterplatte 5 und eine mit der Leiterplatte 5 verbundene Leiterplatte 7 auf. Die Leiterplatten 5 und 7 sind zueinander parallel angeordnet, wobei zwischen den Leiterplatten 5 und 7 wenigstens flächenabschnittsweise eine Zwischenschicht 33 angeordnet ist, welche die Leiterplatten 5 und 7 miteinander verbindet. Die Leiterplatten 5 und 7 sind beispielsweise faserverstärkte, insbesondere glasfaserverstärkte Epoxidharz-Leiterplatten. Die Leiterplattenanordnung 1 bildet in diesem Ausführungsbeispiel eine mehrlagige Leiterplatte, wobei die Leiterplatten 5 und 7 jeweils eine Lage bilden, welche die Zwischenschicht 33, auch Innenlage genannt, zwischeneinander einschließen.

Die Zwischenschicht 33 ist beispielsweise durch eine Epoxidharz-Schicht gebildet. Die Leiterplatten 5 und 7 weisen jeweils auf wenigstens einer Seite eine Kupferfolie auf. Die Kupferfolie kann beispielsweise durch eine RCC-Folie (RCC = Resin-Coated-Copper) gebildet sein. Die Leiterplattenanordnung 1 weist in diesem Ausführungsbeispiel auch mehrere elektronische Bauelemente auf. Dargestellt sind elektronische Bauelemente 14 und 16, welche jeweils auf einer Seite der Leiterplatte 7 angeordnet sind. Die Bauelemente 14 und 16 sind in diesem Ausführungsbeispiel durch einen integrierten Schaltkreis gebildet. Die Leiterplattenanordnung 1 weist auch elektronische Bauelemente 20 und 22 auf, welche jeweils als Kondensatoren ausgebildet sind. Die Bauelemente 20 und 22 sind jeweils in der Zwischenschicht 33, und somit zwischen den Leiterplatten 5 und 7 angeordnet. Dargestellt ist auch ein elektronisches Bauelement 18, in diesem Ausführungsbeispiel ein integrierter Schaltkreis, welcher auf einer Seite der Leiterplatte 5 angeordnet und mit der Leiterplatte 5, insbesondere Kupferbahnen der Leiterplatte 5 verbunden ist.

Die Leiterplatte 7 weist einen Flächenbereich 9 auf, welcher - beispielsweise mittels Sägen - von der Leiterplatte 7 getrennt worden ist. Der Flächenbereich 9 bildet somit eine Art Deckel, welcher von einem den Deckel umlaufenden Spalt 25 umgeben ist. Der Spalt 25 ist beispielsweise durch Sägen oder Laserschneiden der Leiterplatte 7 erzeugt. Vorteilhaft kann der Spalt vor einem Verbinden der Leiterplatte 7 mit der Leiterplatte 5 erzeugt worden sein. Bei dünnen Leiterplatten können mehrere Leiterplatten aufeinandergelegt und gemeinsam lasergeschnitten oder gesägt werden. So können die dünnen Leiterplatten nicht brechen, weiter vorteilhaft können aufwandsgünstig mehrere Leiterplatten in einem Verfahrensschritt erzeugt werden.

Der Flächenbereich 9 der Leiterplatte 7 ist mittels eines Federelements 11 mit der Leiterplatte 5 verbunden. Das Federelement 11 ist in diesem Ausführungsbeispiel durch einen Silikongummi gebildet. Das Federelement 11 weist in diesem Ausführungsbeispiel auch dämpfende Eigenschaften auf.

Auf dem Flächenbereich 9 der Leiterplatte 7 ist auch ein Sensor 13 angeordnet. Der Sensor 13 ist beispielsweise ein Drucksensor, insbesondere ein Mikrofon, ein Beschleunigungssensor oder ein Drehratensensor. Der Sensor 13 ist mittels Bond-Drähten 35 und 37 mit der Leiterplatte 7, und dort mit wenigstens einer Kupferleiterbahn verbunden. In einer anderen Ausführungsform ist der Sensor mittels Flip-Chip-Technologie oder mittels Durchkontaktierungen, auch Via genannt, elektrisch verbunden.

Der Sensor 13 bildet zusammen mit dem Flächenbereich 9 der Leiterplatte 7 eine Masse eines schwingfähigen Systems, insbesondere eines Feder-Masse-Systems. Das Federelement 11 ist in diesem Ausführungsbeispiel zwischen den Leiterplatten 5 und 7 angeordnet. Die Zwischenschicht 33 weist im Bereich des Federelements 11 eine Aussparung auf, sodass dort ein Hohlraum gebildet ist, in dem das Federelement 11 angeordnet ist. Das Federelement 11 ist somit in einem sich zwischen den Leiterplatten 7 und 5, insbesondere dem Flächenbereich 9 und der Leiterplatte 5 erstreckenden Hohlraum angeordnet.

Mittels des so gebildeten schwingfähigen Systems kann der Sensor 13 vorteilhaft von der Leiterplatte 5 und den mit der Leiterplatte 5 verbundenen Komponenten von mechanischen Schwingungen entkoppelt werden.

Der umlaufende Spalt 25 ist in diesem Ausführungsbeispiel durch eine klebende Folie 30 abgedeckt. Die klebende Folie 30 ist beispielsweise eine Polyimidfolie, welche den Spalt 25 abdeckt und vorteilhaft zusätzliche dämpfende Eigenschaften aufweist. Wenn der Sensor 13 zusammen mit dem Flächenbereich 9 auf dem Federelement 11 schwingt, so kann sich die Folie 30 mit den Schwingungsbewegungen elastisch mit bewegen und mittels der elastischen Verformungen des Hin- und Herbewegens der Schwingungsbewegung eine zusätzliche Dämpfung zu den Dämpfungseigenschaften des Federelements 11 erzeugen.

Eine Resonanzfrequenz f = ω/2Π des so gebildeten Feder-Masse-Systems berechnet sich gemäß der Formel:

$$\omega = \sqrt{\frac{s}{m}}$$

mit ω = Kreisfrequenz

s = Federsteife des Federelements

m = Masse des Sensors und des Flächenelements:

Figur 2 zeigt eine Aufsicht auf die in Figur 1 in einer Schnittdarstellung dargestellte Leiterplattenanordnung. Dargestellt ist die Leiterplatte 7, welche einen Durchbruch aufweist.

In dem Durchbruch ist das Flächenelement 9 angeordnet, welches kleinere Abmessungen aufweist als der Durchbruch, sodass zwischen dem Flächenbereich 9 und der Leiterplatte 7 in dem Durchbruch ein umlaufender Spalt 25 gebildet ist, welcher den Flächenbereich 9 umschließt: Der Sensor 13 ist auf dem Flächenbereich 9 der Leiterplatte 7 angeordnet und mit diesem verbunden.

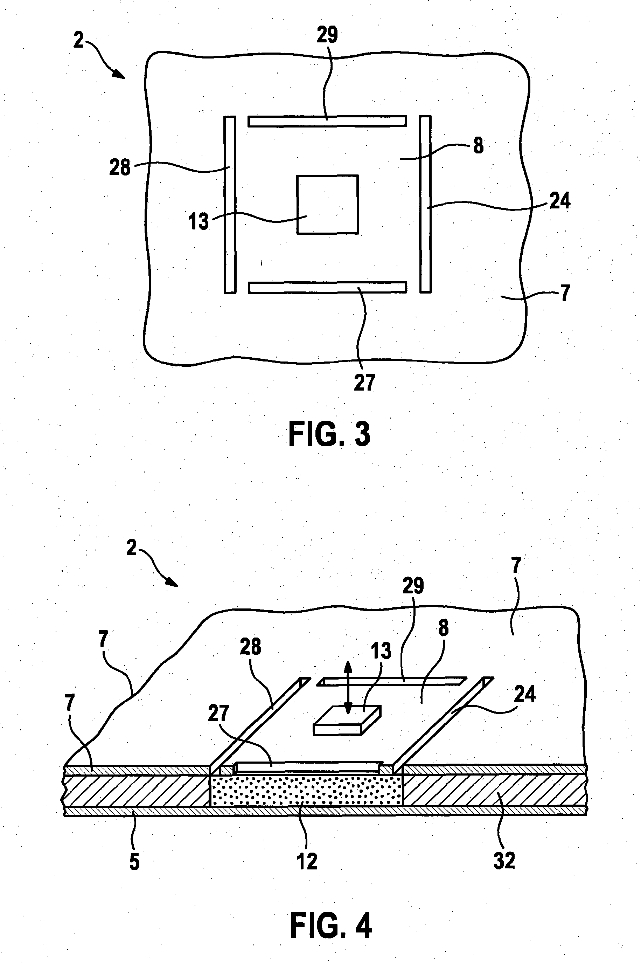

Figur 3 zeigt ein Ausführungsbeispiel für eine Leiterplattenanordnung 2. Die Leiterplattenanordnung 2 weist in diesem Ausführungsbeispiel zwei Leiterplatten 5 und 7 auf. Die Leiterplatte 7 weist einen sich längst in einer Leiterplattenebene der Leiterplatte 7 erstreckenden Durchbruch auf, welcher einen Spalt 29 bildet. Quer zu dem Spalt 29 erstreckt sich im Bereich eines Endes des Spalts 29 ein weiterer Spalt 28. Im Bereich des anderen Endes des Spaltes 29 erstreckt sich ein Spalt 24 in dieselbe Richtung wie der Spalt 28. Die Enden der Spalte 24 und 28, welche dem Spalt 29 zugewandt sind, sind jeweils durch Stege von dem Spalt 29 getrennt, wobei die Stege in der Leiterplatte 7 ausgebildet sind. Die Stege sind beispielsweise durch stehen gebliebenes Leiterplattenmaterial der Leiterplatte 7 beim Sägen der Spalte 28, 29 und 24 gebildet. Die Stege sind somit an die Leiterplatte 7 angeformt. Zu dem Spalt 29 verläuft ein Spalt 27 parallel und im Bereich der von dem Spalt 29 abweisenden Enden der Spalte 24 und 28. Mittels der Spalte 24, 28, 29 und 27 ist somit ein Flächenbereich 8 der Leiterplatte 7 umschlossen, welcher mittels der Stege mit der Leiterplatte 7 verbunden ist. Der Flächenbereich 8 kann somit - an den Stegen aufgehängt - in der Leiterplatte 7 quer zu einer Leiterplattenebene der Leiterplatte 7 hin- und herschwingen. Das Hin- und Herschwingen des Flächenbereichs 8 bewirkt eine Verformung des Flächenbereichs 8, welche beispielsweise im Falle einer ersten Schwingungsmode zu den Endbereichen einer Schwingungsamplitude hin eine Art Kissenform beschreibt.

Auf dem Flächenbereich 8 ist ein Sensor 13 angeordnet. Der Sensor 13 ist beispielsweise ein Drucksensor, ein Beschleunigungssensor oder ein Mikrofon.

Figur 4 zeigt die in Figur 3 in einer Aufsicht dargestellte Leiterplattenanordnung 2 in einer Schnittdarstellung. Der Schnitt verläuft durch den Spalt 27. Dadurch wird der mehrschichtige Aufbau der mehrlagigen Leiterplattenanordnung, umfassend in diesem Ausführungsbeispiel drei Lagen, nämlich die Leiterplatte 5 und die Leiterplatte 7 und eine zwischen diesen angeordnete Zwischenschicht 32. Die Zwischenschicht 32 weist in diesem Ausführungsbeispiel einen Hohlraum auf, in dem ein Dämpfungselement 12 angeordnet ist. Das Dämpfungselement 12 ist beispielsweise durch einen Kunststoff-Schaum, insbesondere Polyurethanschaum, durch einen Silikongummi oder durch ein Gel-Element, insbesondere ein Silikongel-Element gebildet.

Der Sensor kann zusammen mit dem Flächenbereich 8 quer zu einer Leiterplattenebene der Leiterplatte 7 hin- und herschwingen, wobei der Flächenbereich 8 an den Stegen aufgehängt ist und mittels der Stege mit der Leiterplatte 7 verbunden ist.

Die Schwingung des Flächenbereichs 8, insbesondere eine Resonanzfrequenz, wird somit im Wesentlichen durch eine Biegesteife des Leiterplattenmaterials der Leiterplatte 7 und dessen Größe bestimmt. Das Leiterplattenmaterial ist beispielsweise faserverstärktes, insbesondere glasfaserverstärktes Epoxidharz. Die Schwingungsamplitude der Schwingung des Flächenbereichs 8 wird in diesem Ausführungsbeispiel sowohl durch dämpfende Eigenschaften der Leiterplatte 7, insbesondere des Flächenbereichs 8 der Leiterplatte 7 selbst bestimmt, als auch durch die Dämpfungseigenschaften des Dämpfungselements 12, welches den Flächenbereich 8 mit der Leiterplatte 5 verbindet und in dem Zwischenraum zwischen dem Flächenbereich 8 und der Leiterplatte 5 angeordnet ist. Die Resonanzfrequenz des schwingfähigen Systems lässt sich beispielsweise bei vorgegebener Biegesteife des Flächenelements 8 durch eine Länge der Spalte 24, 27, 28 und 29 festlegen. Die Resonanzfrequenz kann beispielsweise empirisch ermittelt werden.

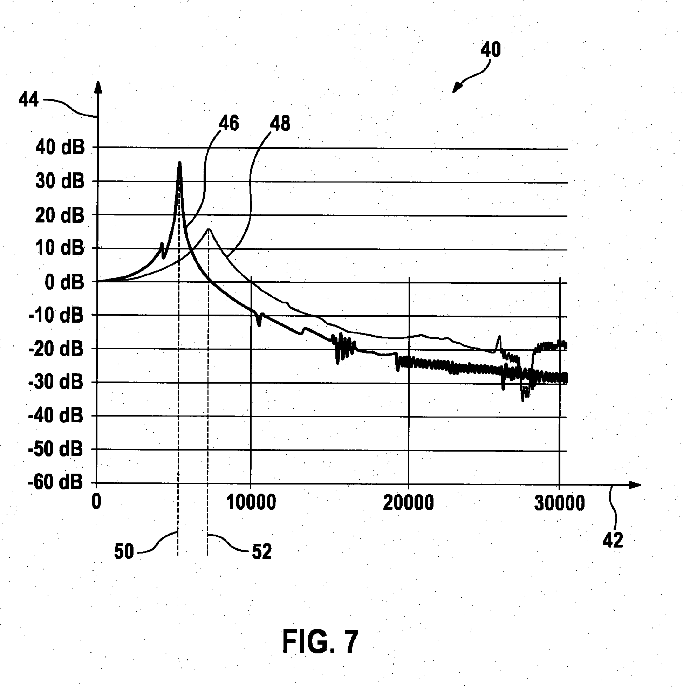

Ein Frequenzverlauf der Schwingung des Flächenbereichs 8 ist in Figur 7 dargestellt.

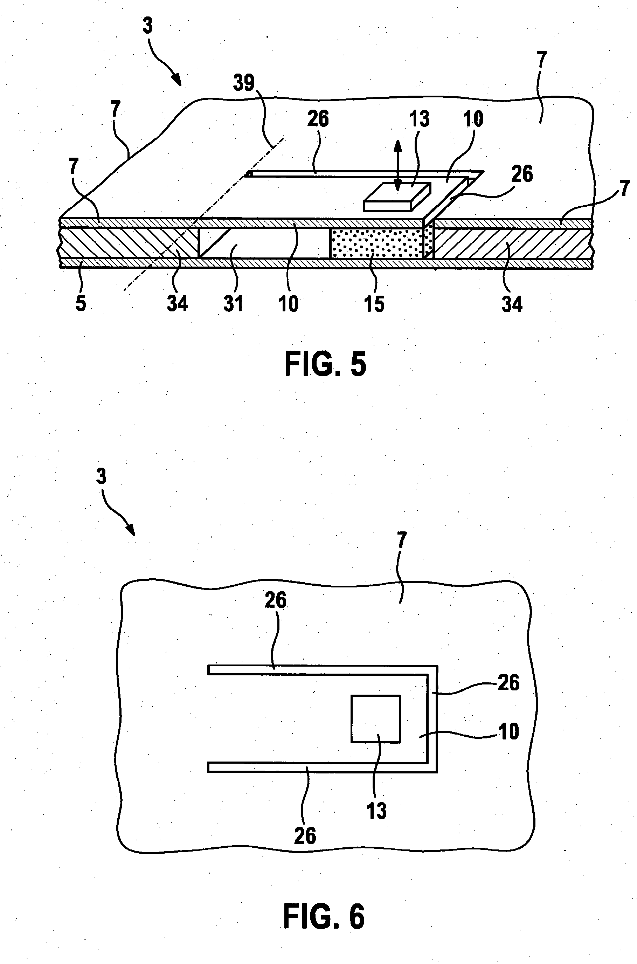

Figur 5 zeigt ein Ausführungsbeispiel für eine Leiterplattenanordnung 3. Die Leiterplattenanordnung 3 umfasst in diesem Ausführungsbeispiel drei Lagen, von denen jeweils eine Lage durch eine faserverstärkte Leiterplatte, nämlich in diesem Ausführungsbeispiel eine Leiterplatte 5 und eine Leiterplatte 7 gebildet sind. Die Leiterplatten 5 und 7 sind mit einer Zwischenschicht 34 miteinander verbunden: Die Zwischenschicht 34 ist beispielsweise durch eine Epoxidharz-Schicht gebildet. Die Zwischenschicht 34 weist einen Hohlraum 31 auf, in dem ein Dämpfungselement 15 angeordnet ist. Das Dämpfungselement 15 füllt in diesem Ausführungsbeispiel den Hohlraum 31 nur teilweise aus. Die Leiterplatte 7 weist in diesem Ausführungsbeispiel einen U-förmigen Durchbruch auf, welcher den U-förmigen Spalt 26 bildet.

Der U-förmige Spalt umschließt einen Flächenbereich 10 der Leiterplatte 7, wobei zwischen dem Flächenbereich 10 der Leiterplatte 7 und die Leiterplatte 5 sich der Hohlraum 31 erstreckt. Der Flächenbereich 10 weist in diesem Ausführungsbeispiel eine längsgestreckte Form auf. Der Flächenbereich 10 kann somit beginnend .von einer Linie 39, welche die Enden der U-Schenkel des Spaltes 26 verbindet, in den Hohlraum 31 hinein und aus der Leiterplattenoberfläche 7 heraus schwingern.

Der Flächenbereich 10 kann sich dabei - ähnlich einem Sprungbrett - entlang seiner Längserstreckung federnd durchbiegen. Die Federeigenschaften, insbesondere eine Resonanzfrequenz des so gebildeten schwingungsfähigen Systems sind im Wesentlichen durch die Biegesteife des Flächenelements 10 entlang seiner Längserstreckung, sowie bei festgelegter Breite des Flächenelements 10 durch die freischwingende Länge des Flächenelements 10 bestimmt.

Im Bereich eines Endes des Flächenelements 10 ist ein Dämpfungselement 15 angeordnet. Das Dämpfungselement 15 verbindet einen Endbereich des Flächenelements 10 mit der Leiterplatte 5. Das Dämpfungselement 15 ist in dem Hohlraum 31 zwischen der Leiterplatte 5 und dem Flächenbereich 10 angeordnet. Mittels des Dämpfungselements 15 kann die Schwingungsbewegung des Flächenbereichs 3 quer zu Leiterplattenebene der Leiterplatte 7 gedämpft werden. Das Dämpfungselement 15 ist beispielsweise durch ein Silikongummi oder ein Gel-Element, insbesondere Silikongel-Element gebildet.

Figur 6 zeigt eine Aufsicht auf die in Figur 5 bereits dargestellte Leiterplattenanordnung 3. Dargestellt ist der Sensor 13, welcher im Bereich eines Endes des sich längserstreckenden Flächenbereichs 10, welcher einen Leiterplattenabschnitt der Leiterplatte 7 bildet, mit dem Flächenbereich 10 verbunden ist. Dargestellt ist auch der den Flächenbereich 10 umschließende Spalt 26. Der Spalt 26 kann beispielsweise mittels Sägen oder Laserschneidens erzeugt worden sein.

Figur 7 zeigt eine Übertragungsfunktion einer Schwingung des in Figur 4 dargestellten Flächenbereichs 8 der Leiterplatte 7. Mit dem Flächenbereich 8 ist der Sensor 13 verbunden. Der Sensor 13 bildet somit zusammen mit dem Flächenbereich 8 ein schwingfähiges System. Figur 7 zeigt ein Diagramm 40. Das Diagramm 40 weist eine Frequenzachse, 42 und eine Amplitudenachse 44 auf. Auf der Amplitudenachse 44 ist das Übertragungsmaß der Schwingung in Dezibel aufgetragen. Das Diagramm 40 zeigt eine Übertragungsfunktion 46 einer ungedämpften Schwingung des Flächenbereichs 8. Bei der ungedämpften Schwingung des Flächenbereichs 8 weist die Leiterplattenanordnung 2 kein Dämpfungselement 12 auf. Sichtbar ist eine ausgeprägte Resonanzfrequenz 50 des Flächenelements 8. Die Übertragungsfunktion 46 fällt zu höheren Frequenzen hin stark ab. Dadurch ergibt sich eine Dämpfung des schwingfähigen Systems zu höheren Frequenzen hin. Dadurch kann das schwingfähige System vorteilhaft zu höheren Frequenzen hin entkoppelt werden.

Dargestellt ist auch eine Übertragungsfunktion 48. Die Übertragungsfunktion 48 repräsentiert eine Schwingung des Flächenbereichs 8, welcher mittels des Dämpfungselements 12 mit der Leiterplatte 5 verbunden ist. Dargestellt ist auch eine Resonanzfrequenz 52, welche größer ist als die Resonanzfrequenz 50. Sichtbar ist eine kleinere Schwingungsamplitude im Bereich der Resonanz 52 als im Bereich der Resonanz 50 der Übertragungsfunktion 46. Die kleinere Amplitude wird vorteilhaft durch die Dämpfung des Dämpfungselements 12 bewirkt. Die Übertragungsfunktion fällt beginnend von der Resonanzfrequenz 52 zu höheren Frequenzen hin steil ab, sodass dadurch wirksam eine Schwingungsentkopplung erzeugt werden kann. Die Resonanzfrequenz 50 liegt in diesem Ausführungsbeispiel bei etwa 5000 Hertz, die Resonanzfrequenz 52 bei etwa 7000 Hertz. Sichtbar ist, dass der Sensor 13 beginnend bei Frequenzen größer als 10000 Hertz wirksam von Schwingungen entkoppelt ist. Der Sensor 13 kann somit durch Schwingungen, insbesondere Biegeschwingungen der Leiterplatten 5 und 7 der Leiterplattenanordnung wirksam entkoppelt werden. Vorteilhaft kann so ein Erfassungsbereich des Sensors, insbesondere ein Frequenzbereich des Erfassungsbereichs des Sensors 13, welcher oberhalb der Resonanzfrequenz 50 beziehungsweise 52 liegt, nicht oder nur gering von Schwingungen der Leiterplattenanordnung beeinträchtigt werden.

**Patentansprüche**

1. Leiterplattenanordnung (1, 2, 3) umfassend wenigstens zwei parallel zueinander angeordnete und miteinander verbundene Leiterplatten (5, 7), wobei wenigstens ein Flächenbereich (8, 9, 10) einer Leiterplatte (7) mit einem elektronischen Bauelement (13) verbunden und mittels eines elastisch und/oder dämpfend ausgebildeten Elements (11, 12, 15) mit einer anderen Leiterplatte (5) der Leiterplattenanordnung (1, 2, 3) derart verbunden ist, dass mittels des Flächenbereichs (8, 9, 10) der Leiterplatte (7) und dem Element (11, 12, 15) ein schwingfähiges System, insbesondere ein Feder-Masse-System, ein schwingfähiger Biegestreifen oder eine biegeschwingfähige Platte gebildet ist, wobei das elastisch und/oder dämpfend ausgebildete Element (11, 12,15) zwischen den zwei Leiterplatten (5, 7) angeordnet ist, wobei die andere Leiterplatte (5), welche parallel zu der Leiterplatte benachbart angeordnet ist, ein Schwingungsgegenlager und einen Befestigungspunkt für das Element (11, 12, 15) und den mit dem Element (11, 12, 15) verbundenen Flächenbereich (8, 9, 10) bildet, wobei der Flächenbereich (8, 9, 10) mit der Fläche der Leiterplatte (7) mittels einer Abdeckfolie (30) verbunden ist, so dass ein Zwischenraum, nämlich ein zum Entkoppeln ausgebildeter Spalt (24, 25, 26, 27, 28, 29) zwischen der Leiterplatte (7) und dem schwingfähigen Flächenbereich (8, 9, 10) der Leiterplatte (7) versiegelt ist, und wobei die Abdeckfolie (30) eine kleinere Dickenabmessung aufweist als die Leiterplatte (7).

2. Leiterplattenanordnung (1, 2, 3) nach Anspruch 1,
wobei
die Folie (30) eine Klebefolie ist, welche ausgebildet ist, sich mit den Schwingungsbewegungen elastisch mitzubewegen und mittels der elastischen Verformungen des Hin- und Herbewegens der Schwingungsbewegung eine zusätzliche Dämpfung zu den Dämpfungseigenschaften des Elements (11, 12, 15) zu erzeugen, wobei das Element (11, 12, 15) federnd und dämpfend ausgebildet ist. rubex

3. Leiterplattenanordnung (1, 2, 3) nach Anspruch 1 oder 2,
wobei
das Bauelement (13) ein Schwingungsempfänger ist, welcher ausgebildet ist, in Anhängigkeit einer empfangenen Schwingung ein die Schwingung repräsentierendes Sensorsignal zu erzeugen.

4. Leiterplattenanordnung (1, 2, 3) nach einem der vorhergehenden Ansprüche,
wobei
der Flächenbereich (8, 9, 10) von einer zum Flächenbereich (8, 9, 10) benachbarten Fläche der Leiterplatte (7) von Schwingungen entkoppelt ist, wobei die Leiterplatte (7) eine Aussparung für den Flächenbereich (8, 9, 10) aufweist und der Flächenbereich in der Aussparung angeordnet ist.

5. Leiterplattenanordnung (1, 2, 3) nach einem der vorhergehenden Ansprüche,
wobei
der Spalt U-förmig ausgebildet ist.

6. Leiterplattenanordnung (1, 2, 3) nach einem der vorhergehenden Ansprüche 1 bis 4,
wobei
der Spalt (24, 25, 26, 27, 28, 29) um den Flächenbereich (8, 9, 10) umlaufend ausgebildet ist.

7. Leiterplattenanordnung (1, 2, 3) nach einem der vorhergehenden Ansprüche,
wobei
das Element (11, 12, 15) Silikon aufweist.

8. Leiterplattenanordnung (1, 2, 3) nach einem der vorhergehenden Ansprüche,
wobei
das Element (11, 12, 15) einen Kunststoff-Schaum aufweist.

9. Leiterplattenanordnung (1, 2, 3) nach einem der vorhergehenden Ansprüche,
wobei
das Element (11, 12, 15) in eine Aussparung der Leiterplatte (7) mittels Spritzen auf die andere Leiterplatte (5) eingefügt ist.

10. Schaltungsanordnung mit einer Leiterplattenanordnung (1, 2, 3) nach einem der vorhergehenden Ansprüche,
wobei
wenigstens ein Teil von Bauelementen (13) der Schaltungsanordnung mit einem schwingfähigen Flächenbereich (8, 9, 10) der Leiterplattenanordnung (1, 2, 3) mechanisch oder zusätzlich elektrisch verbunden ist.

## Claims

1. Printed circuit board arrangement (1, 2, 3) comprising at least two printed circuit boards (5, 7) which are arranged parallel to one another and are connected to one another, wherein at least one surface region (8, 9, 10) of one printed circuit board (7) is connected to an electronic component (13) and is connected to another printed circuit board (5) of the printed circuit board arrangement (1, 2, 3) by means of an elastic and/or damping element (11, 12, 15) in such a way that an oscillating system, in particular a spring-mass system, an oscillating bending strip or a flexurally oscillating plate, is formed by means of the surface region (8, 9, 10) of the printed circuit board (7) and the element (11, 12, 15), wherein the elastic and/or damping element (11, 12, 15) is arranged between the two printed circuit boards (5, 7), wherein the other printed circuit board (5) which is arranged adjacent and parallel to the printed circuit board forms an oscillating mating bearing and a fastening point for the element (11, 12, 15) and the surface region (8, 9, 10) which is connected to the element (11, 12, 15), wherein the surface region (8, 9, 10) is connected to the surface of the printed circuit board (7) by means of a covering film or foil (30), so that an intermediate space, specifically a gap (24, 25, 26, 27, 28, 29) which is designed for decoupling, between the printed circuit board (7) and the oscillating surface region (8, 9, 10) of the printed circuit board (7) is sealed, and wherein the covering film or foil (30) has a smaller thickness dimension than the printed circuit board (7).

2. Printed circuit board arrangement (1, 2, 3) according to Claim 1, wherein the film or foil (30) is an adhesive film or foil which is designed to move elastically together with the oscillation movements and to generate damping in addition to the damping properties of the element (11, 12, 15) by means of the elastic deformations of the to and fro movement of the oscillation movement, wherein the element (11, 12, 15) is of resilient and damping design.

3. Printed circuit board arrangement (1, 2, 3) according to Claim 1 or 2, wherein the component (13) is an oscillation receiver which is designed to generate a sensor signal, which represents the oscillation, depending on a received oscillation.

4. Printed circuit board arrangement (1, 2, 3) according to one of the preceding claims, wherein the surface region (8, 9, 10) is decoupled from oscillations from a surface of the printed circuit board (7) which is adjacent to the surface region (8, 9, 10), wherein the printed circuit board (7) has a cutout for the surface region (8, 9, 10) and the surface region is arranged in the cutout.

5. Printed circuit board arrangement (1, 2, 3) according to one of the preceding claims, wherein the gap is of U-shaped design.

6. Printed circuit board arrangement (1, 2, 3) according to one of the preceding Claims 1 to 4, wherein the gap (24, 25, 26, 27, 28, 29) is designed so as to run around the surface region (8, 9, 10).

7. Printed circuit board arrangement (1, 2, 3) according to one of the preceding claims, wherein the element (11, 12, 15) comprises silicone.

8. Printed circuit board arrangement (1, 2, 3) according to one of the preceding claims, wherein the element (11, 12, 15) comprises a plastic foam.

9. Printed circuit board arrangement (1, 2, 3) according to one of the preceding claims, wherein the element (11, 12, 15) is inserted into a cutout in the printed circuit board (7) by means of injection onto the other printed circuit board (5).

10. Circuit arrangement comprising a printed circuit board arrangement (1, 2, 3) according to one of the preceding claims, wherein at least some of components (13) of the circuit arrangement are mechanically or additionally electrically connected to an oscillating surface region (8, 9, 10) of the printed circuit board arrangement (1, 2, 3).

**Revendications**

1. Agencement de cartes de circuits imprimés (1, 2, 3) comprenant au moins deux cartes de circuits imprimés (5, 7) disposées parallèlement les unes aux autres et reliées entre elles, dans lequel au moins une zone de surface (8, 9, 10) d'une carte de circuits imprimés (7) est reliée à un composant électronique (13) et est reliée au moyen d'un élément (11, 12, 15) réalisé de manière élastique ou amortissante à une autre carte de circuits imprimés (5) de l'agencement de cartes de circuits imprimés (1, 2, 3) de manière à ce que, au moyen de la zone de surface (8, 9, 10) de la carte de circuits imprimés (7) et de l'élément (11, 12, 15), un système apte à osciller est formé, en particulier un système masse-ressort, une bande de flexion apte à osciller ou une plaque apte aux oscillations de flexion, dans lequel l'élément (11, 12, 15) réalisé de manière élastique ou amortissante est disposé entre les deux cartes de circuits imprimés (5, 7), dans lequel l'autre carte de circuits imprimés (5), laquelle est disposée de façon adjacente, parallèlement à la carte de circuits imprimés, forme un contre-appui oscillatoire et un point de fixation pour l'élément (11, 12, 15) et la zone de surface (8, 9, 10) reliée à l'élément (11, 12, 15), dans lequel la zone de surface (8, 9, 10) est reliée à la surface de la carte de circuits imprimés (7) au moyen d'un film de recouvrement (30) de sorte qu'un espace intermédiaire, à savoir un interstice (24, 25, 26, 27, 28, 29) réalisé pour le découplage entre la carte de circuits imprimés (7) et la zone de surface apte à osciller (8, 9, 10) de la carte de circuits imprimés (7) est colmaté, et dans lequel le film de recouvrement (30) présente une dimension d'épaisseur inférieure à celle de la carte de circuits imprimés (7).

2. Agencement de cartes de circuits imprimés (1, 2, 3) selon la revendication 1, dans lequel le film (30) est un film adhésif qui est réalisé pour se mouvoir élastiquement avec les mouvements oscillatoires et pour produire, au moyen des déformations élastiques du mouvement de va-et-vient du mouvement oscillatoire, un amortissement supplémentaire par rapport aux propriétés d'amortissement de l'élément (11, 12, 15), dans lequel l'élément (11, 12, 15) est réalisé de manière élastique et amortissante.

3. Agencement de cartes de circuits imprimés (1, 2, 3) selon la revendication 1 ou 2, dans lequel le composant (13) est un récepteur d'oscillations qui est réalisé, en fonction d'une oscillation réceptionnée, pour générer un signal de détection représentant l'oscillation.

4. Agencement de cartes de circuits imprimés (1, 2, 3) selon l'une des revendications précédentes, dans lequel la zone de surface (8, 9, 10) d'une surface de la carte de circuits imprimés (7) voisine de la zone de surface (8, 9, 10) est découplée des oscillations, dans lequel la carte de circuits imprimés (7) présente un évidement pour la zone de surface (8, 9, 10), et la zone de surface étant disposée dans l'évidement.

5. Agencement de cartes de circuits imprimés (1, 2, 3) selon l'une des revendications précédentes, dans lequel l'interstice est réalisé en forme de U.

**6.** Agencement de cartes de circuits imprimés (1, 2, 3) selon l'une des revendications 1 à 4 précédentes, dans lequel l'interstice (24, 25, 26, 27, 28, 29) est réalisé de manière périphérique autour de la zone de surface (8, 9, 10).

**7.** Agencement de cartes de circuits imprimés (1, 2, 3) selon l'une des revendications précédentes, dans lequel l'élément (11, 12, 15) présente du silicone.

**8.** Agencement de cartes de circuits imprimés (1, 2, 3) selon l'une des revendications précédentes, dans lequel l'élément (11, 12, 15) présente une mousse en matière plastique.

**9.** Agencement de cartes de circuits imprimés (1, 2, 3) selon l'une des revendications précédentes, dans lequel l'élément (11, 12, 15) est inséré dans un évidement de la carte de circuits imprimés (7) au moyen d'une injection sur l'autre carte de circuits imprimés (5).

**10.** Agencement de circuits avec un agencement de cartes de circuits imprimés (1, 2, 3) selon l'une des revendications précédentes, dans lequel au moins une partie des composants (13) de l'agencement de circuits est reliée mécaniquement, ou additionnellement électriquement à une zone de surface (8, 9, 10) apte à osciller de l'agencement de cartes de circuits imprimés (1, 2, 3).

FIG. 1

FIG. 2

**FIG. 3**

**FIG. 4**

**FIG. 5**

**FIG. 6**

FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011075384 A1
- US 2009082995 A1